# EUROPEAN PATENT SPECIFICATION

(11) **EP 1 859 488 B1**
(45) Date of publication and mention of the grant of the patent: **21.11.2018**
(21) Application number: 06707582.0
(22) Date of filing: 16.03.2006
(51) Int. Cl.: H01L 31/18, H01L 31/0216, H01L 31/0224, H01L 31/02

(54) **PHOTOVOLTAIC CELL WITH THICK SILICON OXIDE AND SILICON NITRIDE PASSIVATION AND FABRICATION METHOD**
SOLARZELLEN MIT DICKEM SILIZIUMOXID UND SILIZIUMNITRID ZUR PASSIVIERUNG UND ENTSPRECHENDES HERSTELLUNGSVERFAHREN
CELLULE SOLAIRE AVEC UNE COUCHE ÉPAISSE DE PASSIVATION D'OXYDE DE SILICIUM ET DE NITRURE DE SILICIUM ET SON PROCÉDÉ DE FABRICATION

(30) Priority: 16.03.2005 US 662613 P; 09.09.2005 EP 05447200
(43) Date of publication of application: 28.11.2007
(73) Proprietor: IMEC VZW, 3001 Leuven (BE)
(72) Inventor: AGOSTINELLI, Guido, B-1200 Bruxelles (BE); BEAUCARNE, Guy, B-3050 Oud-Heverlee (BE); CHOULAT, Patrick, 3010 Kessel-lo (BE)
(74) Representative: DenK iP
(86) International application number: PCT/EP2006/002409
(87) International publication number: WO 2006/097303

(56) References cited:
- US-A1- 2005 022 863
- OKAMOTO S ET AL: "LOW-HIGH HETEROJUNCTION OF C-SI SUBSTRATE AND MUC-SI:H FILM UNDER REAR CONTACT FOR IMPROVEMENT OF EFFICIENCY" WORLD CONFERENCE ON PHOTOVOLTAIC ENERGY. WAIKOLOA, DEC. 5 - 9, 1994, NEW YORK, IEEE, US, vol. VOL. 2 CONF. 1, 5 December 1994 (1994-12-05), pages 1295-1298, XP000680076 ISBN: 0-7803-1460-3
- AGOSTINELLI, G ET AL: "SURFACE PASSIVATION OF SILICON BY MEANS OF NEGATIVE CHARGE DIELECTRICS" PROCEEDINGS OF 19TH EUROPEAN PHOTOVOLTAIC SOLAR ENERGY CONFERENCE, 7 June 2004 (2004-06-07), pages 132-134, XP002383851 PARIS, FRANCE
- B. S. RICHARDS: "Novel Uses of Titanium Dioxide for Silicon Solar Cells" [Online] April 2002 (2002-04), , SYDNEY AUSTRALIA , XP002383854 ISBN: 0 7334 1971 2 Retrieved from the Internet: URL:http://www.library.unsw.edu.au/~thesis /adt-NUN/uploads/approved/adt-NUN20041129. 093521/public/02whole.pdf> [retrieved on 2006-06-02] abstract paragraph [5.3.2] paragraph [5.4.]
- POORTMANS, J: "From solar cells in thin Si-substrates to thin-film crystalline Si solar cells" EUROPV 2004, [Online] 15 October 2004 (2004-10-15), XP002383852 Kranjska Gora, Slovenia Retrieved from the Internet: URL:http://paris.fe.uni-lj.si/pvnet/europv /europv2004/PPT/08_Poortmans_EUROPV2004.pd f> [retrieved on 2006-06-02]
- GEE J M ET AL: "Emitter wrap-through solar cell" PROCEEDINGS OF THE PHOTOVOLTAIC SPECIALISTS CONFERENCE. LOUISVILLE, MAY 10 - 14, 1993, NEW YORK, IEEE, US, vol. CONF. 23, 10 May 1993 (1993-05-10), pages 265-270, XP010113396 ISBN: 0-7803-1220-1
- ZHAO JIANHUA ET AL: "19.8&percent; efficient honeycomb” textured multicrystalline and 24.4&percent; monocrystalline silicon solar cells" APPLIED PHYSICS LETTERS, AIP, AMERICAN INSTITUTE OF PHYSICS, MELVILLE, NY, US, vol. 73, no. 14, 5 October 1998 (1998-10-05), pages 1991-1993, XP012021086 ISSN: 0003-6951
- SZLUFCIK J ET AL: "Low-Cost Industrial Technologies of Crystalline Silicon Solar Cells" PROCEEDINGS OF THE IEEE, IEEE. NEW YORK, US, vol. 85, no. 5, May 1997 (1997-05), pages 711-730, XP011043842 ISSN: 0018-9219
- VERBEEK ET AL: "Mechanically grooved high-efficinecy silicon solar cells with self-aligned metallisation" CONFERENCE RECORD OF THE 25TH. IEEE PHOTOVOLTAIC SPECIALISTS CONFERENCE 1996. WASHINGTON, MAY 13 - 17, 1996, CONFERENCE RECORD OF THE IEEE PHOTOVOLTAIC SPECIALISTS CONFERENCE, NEW YORK, IEEE, US, vol. CONF. 25, 13 May 1996 (1996-05-13), pages 521-524, XP002121004 ISBN: 0-7803-3167-2
- HO A W Y ET AL: "Buried contact solar cells with innovative rear localised contacts" PROGRESS IN PHOTOVOLTAICS. RESEARCH AND APPLICATIONS, JOHN WILEY AND SONS, CHICHESTER, GB, vol. 12, no. 4, June 2004 (2004-06), pages 297-308, XP002349703 ISSN: 1062-7995
- MICHIELS ET AL: "HYDROGEN PASSIVATION OF POLYCRYSTALLINE SILICON SOLAR CELLS BY PLASMA DEPOSITION OF SILICON NITRIDE" RECORD OF THE PHOTOVOLTAIC SPECIALISTS CONFERENCE. KISSIMIMEE, MAY 21, vol. VOL. 1 CONF. 21, 21 May 1990 (1990-05-21), pages 638-643, XP000480341
- GRUENBAUM P E ET AL: "STABLE PASSIVATIONS FOR HIGH-EFFICIENCY SILICON SOLAR CELLS" RECORD OF THE PHOTOVOLTAIC SPECIALISTS CONFERENCE. KISSIMIMEE, MAY 21, vol. VOL. 1 CONF. 21, 21 May 1990 (1990-05-21), pages 317-322, XP000480305
- CHEN Z ET AL: "SILICON SURFACE AND BULK DEFECT PASSIVATION BY LOW TEMPERATURE PECVD OXIDES AND NITRIDES" WORLD CONFERENCE ON PHOTOVOLTAIC ENERGY. WAIKOLOA, DEC. 5 - 9, 1994, NEW YORK, IEEE, US, vol. VOL. 2 CONF. 1, 5 December 1994 (1994-12-05), pages 1331-1334, XP000680085 ISBN: 0-7803-1460-3
- GLUNZ S. W. ET AL: "Comparison of Different Dielectric Passivation Layers for Application in Industrially Feasible High-Efficiency Crystalline Silicon Solar Cells" PROC. 20TH EUROPEAN PHOTOVOLTAIC SOLAR ENERGY CONFERENCE AND EXHIBITION, 6 June 2005 (2005-06-06), - 10 June 2005 (2005-06-10) XP002383910 Barcelona, Spain Retrieved from the Internet: URL:http://www.scirus.com/srsapp/sciruslin k?src=web&url=http%3A%2F%2Fwww.ise.fhg.de% 2Fenglish%2Fcurrent_topics%2Fevents%2Feven ts2005%2Fpdf%2Fbarcelona%2FGlunz_2CP.1.4.p df> [retrieved on 2006-06-01]
- POORTMANS J ET AL: "Photovoltaics and Microelectronics: Going Theri Own Way or Still Cross-Fertilizing?" - June 2005 (2005-06) XP002383911 Retrieved from the Internet: URL:http://www.imec.be/wwwinter/energy/FIL ES/Jef1.pdf> [retrieved on 2006-06-01]
- ROHATGI A ET AL: "EFFECTIVE PASSIVATION OF THE LOW RESISTIVITY SILICON SURFACE BY A RAPID THERMAL OXIDE/PECVD SILICON NITRIDE STACK AND ITS APPLICATION TO PASSIVATED REAR AND BIFACIAL SI SOLAR CELLS", 2ND WORLD CONFERENCE ON PHOTOVOLTAIC SOLAR ENERGY CONVERSION. / 15TH EUROPEAN PV SOLAR ENERGY CONFERENCE. / 27TH US IEEE PHOTOVOLTAICS SPECIALISTS CONFERENCE. / 10TH ASIA/PACIFIC PV SCIENCE AND ENGINEERING CONFERENCE. VIENNA, AUSTRIA, JULY 6 - 10, 19, 6 July 1998 (1998-07-06), pages 1566-1569, XP001138013, ISBN: 978-92-828-5419-8

## Description

### Field of the invention

The present invention relates to the field of photovoltaic cells. More particularly it relates to a method of manufacturing photovoltaic cells and to photovoltaic cells thus obtained.

### Background of the invention

Significant cost reduction of bulk crystalline silicon solar cells requires the removal of the technological barriers that impede the development of a high throughput, low cost, and reliable industrial process on thin substrates. Present industrial surface conditioning and rear surface passivation processes do not meet the requirements for yield and performance on thin substrates. A well-established process step such as the full area, screen printed Al-Alloyed BSF (Back Surface Field) is to be abandoned, due to insufficient performance and excessive warping of the wafers below 200 µm. There exist a variety of solutions for laboratory scale production, but these are not applicable to commercial quality material, nor would guarantee cost effectiveness and throughput.

The major problem is that of passivating the rear surface and, at the same time, providing (local) electrical contacts of an ohmic nature and a limited surface recombination velocity to the base.

Engineering a dielectric with surface passivation properties that are resistant to contact firing with a process that is not harmful to the bulk lifetime of commercial quality materials (e.g. mono-crystalline or Cz-Si, multi-crystalline or mc-Si), and that does not interact with the rear side metallisation is all but a trivial task. Most dielectrics lose their passivation properties during the rapid thermal treatment, which is necessary to fire the front contacts through the ARC, and it is known that interaction between the rear side aluminum and the dielectric can jeopardize the cell efficiency, despite excellent results of surface passivation on bifacial samples reported in literature for a variety of dielectric layers on silicon. Nor is it trivial to integrate such layer in a complete solar cell process sequence, given the repeated high temperature treatments and cleaning/etching steps that need to be carried out in a given sequence.

In "Effective passivation of the low resistivity silicon surface by a rapid thermal oxide/plasma silicon nitride stack", Applied Physics Letters, Volume 72, Number 15, 13 April 1998, a passivation process is described for a low resistivity silicon surface. A rapid thermal oxide (RTO) is deposited by rapid thermal processing (RTP) at 900° for 5 minutes, followed by the deposition of a SiN layer by Plasma Enhanced Chemical Vapour Deposition process (PECVD). An effect is shown of the RTO temperature on the passivation of the stack. The RTO layer is about 7.9 nm thick. No photovoltaic cell production process is performed. No solar cell rear surface passivation process is performed nor analysed.

In "The effect of Low and High Temperature Anneals on the Hydrogen Content and Passivation of Si Surface with SiO2 and SiN Films", Journal of The Electrochemical Society, 146 (5) 1921-1924 (1999) different Si surface passivation schemes are investigated and compared. It is suggested that the release of hydrogen from SiN during the anneal further passivates the RTO/Si interface underneath. The examples comprise thin oxide layers of about 10 nm. For low quality oxides a lower passivation property is indicated. No solar cell production process is performed nor analysed.

In "Investigation of various surface passivation layers using oxide/nitride stacks of silicon solar cells", Lee, J.Y.; Dicker, J.; Rein, S.; Glunz, S.W.; Proceedings of 3rd World Conference on Photovoltaic Energy Conversion, Osaka 2003, 12-16 May 2003, p1069 - p1072 Vol.2, different surface passivation processes based on Classical Thermal Oxidation (CTO), RTO, SiNx and oxide/nitride stacks are tested and introduced in solar cells. It is concluded a) that oxide/nitride stack passivation relies on a combined native low density of interface states at the SiO₂/Si interface and high fixed charge density at the SiNx/SiO₂ interface and b) that nevertheless oxide/nitride stacks have a weak front and rear surface passivation when introduced in solar cells. Point a) suggests that for passivation to be effective,
- the oxide/silicon interface shall be natively of a good quality, and
- the oxide shall be as thin as possible, because the thinner the oxide, the stronger the field effect passivation due to the nitride charges.

### Aim of the invention

It is an aim of this invention to provide photovoltaic cells and a method for producing a photovoltaic cell, which alleviates or avoids some problems of the prior art and reduces the production cost.

### Summary of the invention

In a first aspect of the present invention, a method for the production of a photovoltaic device as for instance a solar cell is disclosed, comprising:
i. providing a semiconductor substrate, e.g. a silicon substrate, having a front main surface for collecting impinging light, e.g. sunlight, and a rear surface opposite to the front main surface,
ii. depositing a dielectric layer on said rear surface, wherein the dielectric layer has a thickness larger than 100 nm, preferably larger than 120 nm, still more preferred larger than 150 nm or larger than 200 nm,
iii. depositing a passivation layer comprising hydrogenated SiN on top of said dielectric layer, and
iv. forming back contacts through said dielectric layer and said passivation layer.

The step of forming the back contacts comprises forming holes in the dielectric layer and the passivation layer, and depositing a layer of contacting material onto the passivation layer, hereby filling the holes. The method furthermore comprising applying a high temperature step to the layer of contacting material, in which the high temperature step is a contact firing step and is performed at a temperature higher than 730 degrees Celsius and below 960 degrees Celsius.

In an embodiment of the first aspect of the present invention a method for the production of a photovoltaic device as for instance a solar cell is disclosed, comprising:
i. providing a semiconductor substrate, e.g. a silicon substrate, having a front main surface for collecting impinging light, e.g. sunlight, and a rear surface opposite to the front main surface,
ii. depositing a SiN layer or a SiN:H layer on said rear surface, wherein said SiN layer or SiN:H layer has a thickness larger than 100 nm, preferably larger than 120 nm, still more preferred larger than 150 nm, larger than 180 nm or larger than 200 nm,
iii. forming back contacts through said SiN layer or SiN:H layer.

In case of bifacial solar cells, both the front main surface and the rear surface are adapted to receive impinging light. In that case, the front main surface is that surface adapted for receiving the largest fraction of the impinging light.

The layer of hydrogenated SiN functions as a passivating layer in that it releases hydrogen (during a subsequent high-temperature step) and induces the charges that allow for a good surface passivation of the dielectric/substrate interface.

Depositing a dielectric layer on the rear surface may comprise depositing a low quality dielectric layer. Depositing a dielectric layer on the rear surface may comprise depositing a SiN layer, or a hydrogenated SiN layer. Alternatively, depositing a dielectric layer on the rear surface may comprise depositing a low quality oxide. The low quality oxide may comprise low quality amorphous oxide, e.g. amorphous silicon oxide, which can reduce production costs when compared to production of high quality oxide. The low-quality amorphous oxide may be any of APCVD pyrolithic oxide, spin-on oxide, spray-on oxide or dip oxide. In embodiments of the present invention, the dielectric layer may be a deposited dielectric layer. Deposited dielectric layers are typically of lower quality than grown dielectric layers.

In embodiments of the present invention, the production rate (which can be growth rate or deposition rate) of the dielectric layer, expressed in layer thickness per minute (min), may be higher than 5 nm per min, or higher than 10 nm per min, or higher than 20 nm per min, or higher than 30 nm per min, or higher than 50 nm per min.

A grown silicon dioxide is formed as the product of a reaction between the Si of the substrate and oxygen provided through the gas phase. In the case of a deposited oxide or dielectric none of the reagents comes from the substrate or the silicon layer. A low-quality dielectric layer, e.g. amorphous oxide, can for instance be a Spin-on oxide or APCVD (Atmospheric pressure chemical vapour deposition) pyrolithic oxide (pyrox), spin-on, spray-on or dip oxide. It can be for instance a silicon oxide, TiO2 (e.g. deposited by solgel), or Al2O3/TiO2 pseudobinary alloys (PBAs).

Depositing the dielectric layer at certain temperatures may bring certain advantageous effects, some of which are described below. In embodiments of the present invention, the deposition temperature may be lower than 600°C, hereby allowing processing without thermal poisoning of substrates. In embodiments of the present invention, the dielectric may be deposited e.g. by PECVD at a temperature below 500°C. In embodiments of the present invention, the deposition temperature may be lower than 410°C, which can be achieved by using for instance pyrox (having a typical deposition temperature of 404°C). In embodiments of the present invention the dielectric layer may be deposited by low temperature PEVCD (< 300°C). In other embodiments of the present invention, the deposition may be done at Room Temperature e.g. by spin-on, spray-on, dip or any other deposition from liquid, sol, solgel. The resulting dielectric layer may need further curing at higher temperatures, which can happen during further cell processing.

In a second embodiment of the first aspect of the present invention, a method for the production of a photovoltaic device as for instance a solar cell is disclosed, comprising:
i. providing a semiconductor substrate, e.g. a silicon substrate, having a front main surface for collecting impinging light, e.g. sunlight, and a rear surface opposite to the front main surface,
ii. depositing a dielectric layer stack on said rear surface, wherein the dielectric layer stack comprises a sub-stack of dielectric layers and/or wide bandgap semiconductor layers, the sub-stack having a thickness larger than 100 nm, preferably larger than 150 nm, preferably larger than 200 nm, the dielectric layer stack having a thickness larger than 200 nm, preferably larger than 250 nm, preferably larger than 300 nm, and
iii. forming back contacts through said dielectric layer stack.

Depositing a dielectric layer stack on said rear surface may comprise depositing the sub-stack of dielectric layers and/or wide bandgap semiconductor layers on the rear surface, and depositing a passivation layer on top of the sub-stack. In that case, the thickness of the passivation layer is not included in the thickness of the stack. The passivation layer can have any suitable thickness. The passivation layer may be a SiN layer, preferably a hydrogenated SiN layer.

Depositing a sub-stack of dielectric layers and/or wide bandgap semiconductor layers on the rear surface may comprise depositing a low quality dielectric layer, such as a low quality oxide. The low quality oxide may comprise low quality amorphous oxide, e.g. amorphous silicon oxide, which can reduce production costs when compared to production of high quality oxide. The low-quality amorphous oxide may be any of APCVD pyrolithic oxide, spin-on oxide, spray-on oxide or dip oxide. In embodiments of the present invention, the dielectric layer may be a deposited dielectric layer. Deposited dielectric layers are typically of lower quality than grown dielectric layers.

In embodiments of the present invention, the production rate (which can be growth rate or deposition rate) of the dielectric layers and/or wide bandgap semiconductor layers, expressed in layer thickness per minute (min), may be higher than 5 nm per min, or higher than 10 nm per min, or higher than 20 nm per min, or higher than 30 nm per min, or higher than 50 nm per min.

A grown silicon dioxide is formed as the product of a reaction between the Si of the substrate and oxygen provided through the gas phase. In the case of a deposited oxide or dielectric none of the reagents comes from the substrate or the silicon layer. A low-quality dielectric layer, e.g. amorphous oxide, can for instance be a Spin-on oxide or APCVD (Atmospheric pressure chemical vapour deposition) pyrolithic oxide (pyrox), spin-on, spray-on or dip oxide. It can be for instance a silicon oxide, TiO2 (e.g. deposited by solgel), or Al2O3/TiO2 pseudobinary alloys (PBAs).

Depositing the sub-stack of dielectric layers and/or wide bandgap semiconductor layers at certain temperatures may bring certain advantageous effects, some of which are described below. In embodiments of the present invention, the deposition temperature may be lower than 600°C, hereby allowing processing without thermal poisoning of substrates. In embodiments of the present invention, the sub-stack of dielectric layers and/or wide bandgap semiconductor layers may be deposited e.g. by PECVD at a temperature below 500°C. In embodiments of the present invention, the deposition temperature may be lower than 410°C, which can be achieved by using for instance pyrox (having a typical deposition temperature of 404°C). In embodiments of the present invention the sub-stack of dielectric layers and/or wide bandgap semiconductor layers may be deposited by low temperature PEVCD (< 300°C). In other embodiments of the present invention, the deposition may be done at room temperature e.g. by spin-on, spray-on, dip or any other deposition from liquid, sol, solgel. The resulting sub-stack of dielectric layers and/or wide bandgap semiconductor layers may need further curing at higher temperatures, which can happen during further cell processing.

In any of the embodiments of the first aspect of the present invention, if a silicon substrate is used, any kind of silicon substrate may be used. Some Examples of silicon substrates are Czochralski Si (cz-Si) wafers, Float-Zone Si (fz-Si) wafers, multicrystalline Si (mc-Si) wafers and Ribbon Si wafers. Some examples of layers are polycrystalline silicon layers which can be put on glass or glass-ceramic, or monocrystalline Si layers obtained by a lift-off process

In any of the embodiments of the first aspect of the present invention, the thickness of the dielectric layer or sub-stack of dielectric layers and/or wide bandgap semiconductor layers may be between 100 nm and 5000 nm, preferably between 100 nm and 4000 nm, more preferred between 100 nm and 3000 nm, still more preferred between 100 nm and 2000 nm, still more preferred between 100 nm and 1500 nm, still more preferred between 150 nm and 1200 nm, more preferably between 200 nm and 1200 nm, still more preferably between 600 nm and 1200 nm or between 800 nm and 1200 nm. Alternatively, the thickness of the dielectric layer or dielectric layer stack may be between 400 nm and 800 nm. In embodiments of the present invention, the minimal thickness of the dielectric layer or dielectric layer stack depends on the material which is employed and is determined by the amount of material which is necessary to act simultaneously as a diffusion mask during emitter diffusion, while still being of use for surface passivation and contact formation. For pyrox Silicon Oxide this is typically about 300 nm, for Al2O3/TiO2 pseudobinary alloys (PBAs) deposited by solgel this is about 150 nm. Those thickness values are only indicative and a deviation of 10%, 20% or more from the given values is possible. Also a combination, or a stack of layers, of different materials are possible and would lead to a pre-determined threshold thickness for the combined diffusion mask, surface passivation and contact formation process.

It is a function of the dielectric layers or wide bandgap semiconductor layers applied at the rear surface of a photovoltaic device, for instance a solar cell, in accordance with the present invention, to increase the distance between the back contact material and the substrate surface. It has been found, surprisingly, that, for a distance between 100 nm and 5000 nm, the larger the distance between the contacting layer at the rear surface of the photovoltaic device, for instance solar cell, and the rear surface of the substrate, the better the achieved passivation results, even with low quality dielectric materials or wide bandgap semiconductor layers being applied. It is an advantage of embodiments of the present invention that sufficient passivation results may be achieved while using low-quality dielectrics. Deposition of such low-quality dielectric layers may be performed by low-cost deposition techniques which may be fast.

In a method according to embodiments of the first aspect of the present invention, forming back contacts comprises forming holes in said dielectric layer and said passivation layer or in said dielectric layer stack possibly provided with a passivation layer, and depositing a layer of contacting material onto said passivation layer or onto said dielectric layer stack, hereby filing said holes.

Forming holes may be performed by applying an etching paste, by mechanical scribing or by laser ablation.

In a method according to embodiments of the present invention, depositing a layer of contacting material may be performed by evaporation, sputtering or screen printing, inkjet printing, stencil printing. Metals can be used as contacting materials, although advantageously Aluminum can be used. The present invention offers advantages when using Aluminum paste, allowing the formation of local BSF (Back Surface Field) contacts. Alternatively, after depositing the passivation layer and firing it, one could deposit, instead of a metal, a p+ (or n+ on n-type substrates) semiconductor (like a-Si) by e.g. PECVD and then deposit a metal on top of it.

In a method according to embodiments of the present invention, the layer of contacting material may be discontinuous. During the step of depositing the layer of contacting material, said contacting material may be deposited essentially in said holes. Different ways of depositing such a discontinuous layer of contact material exist, and are known by a person of ordinary skill.

In embodiments of the present invention, the layer of contacting material may be initially discontinuous. This means that different areas can be covered with contacting material, whereby those different areas are not electrically connected to each other. These areas can be electrically connected later on in order to allow an optimal current flow through the device and/or an external load.

In embodiments of the present invention, the layer of contacting material may be deposited in such way that light can also enter the device from the rear side, thereby allowing the production of bifacial solar cells.

In to embodiments of the present invention, a high temperature step is applied to the layer of contacting material, i.e. a step at a temperature between 600 and 1000 degrees Celsius, such as for example firing of the front and rear contacts in a rapid thermal process (tens of seconds). A distinctive feature over the prior art is that the dielectric layer or dielectric layer stack is resistant to such high temperature step, which is necessary in all industrial solar cells. In addition, during the high temperature step, for instance in a particular embodiment when using a SiNx:H/dielectric stack, the surface passivation of the dielectric/silicon interface is improved. This high temperature step is a contact firing step performed at a temperature higher than 730 degrees Celsius and below 960 degrees Celsius, for maximum about a few tens of seconds. The firing step can be "co-firing" when the front and rear side contact are created at the same time. When this is decoupled, the rear side can be fired above 800 degrees Celsius, and subsequently the front contact can be fired around 750 degrees Celsius (and possibly followed by a forming gas anneal -FGA-) The numbers in the last paragraph are indicative and certain variations are possible (e.g. of about 25%).

In alternative embodiments of the first aspect of the present invention, forming back contacts may be performed by applying a continuous layer of contacting material, e.g. metal, and applying local firing of the layer of contacting material, i.e. local heating e.g. by means of a laser. In this case, the continuous layer of contacting material can also serve as a back mirror.

In still alternative embodiments of the first aspect of the present invention, forming back contacts may be performed by applying a patterned metal layer at the passivated rear surface of the photovoltaic device, for instance solar cell, and applying a general heating step.

A method according to embodiments of the present invention may further comprise a step of diffusion and emitter removal on the surface to be passivated (i.e. rear surface) before depositing said dielectric layer or said dielectric layer stack. However, if the dielectric layer or said dielectric layer stack is suitable for being used as a diffusion mask, these layers may be applied before the formation of the emitter takes place. In this case, no dopants will enter into the substrate at the rear surface of the device, and thus it is advantageous that according to embodiments of the present invention emitter removal on the surface to be passivated may be avoided.

In a method according to embodiments of the present invention, for instance according to the first embodiment of the first aspect of the present invention, a step of diffusion may be applied after the step of depositing a dielectric layer and before the step of depositing a passivation layer.

In the same embodiment, the dielectric layer may be used as a diffusion mask. In advantageous embodiments of the present invention, the dielectric layer can be used simultaneously as a diffusion mask and for the purpose of surface passivation, thereby simplifying the cell process sequence. The dielectric layer can be used as a diffusion mask, whether it is patterned or not. Normally it will not be patterned, and it is just a mask on the full rear surface. It may, however, be patterned e.g. for interdigitated or back contacted solar cells. Later on, the dielectric layer, whether patterned or not, may be locally removed, ablated, etched or patterned in order to create openings for local contacts to the substrate surface.

In embodiments of the present invention, when it is not possible to use the passivation layer as a diffusion mask, a further step can be comprised of diffusion with another mask to be etched off, or maskless diffusion with subsequent rear side parasitic emitter removal before depositing the dielectric layer.

In a method according to embodiments of the present invention, said front main surface may have undergone a typical solar cell front surface processing. A typical solar cell front surface process may comprise texturing of the front surface, diffusion of phosphorus atoms at the front side, etching of the phosphorus glass and the deposition of a silicon nitride layer on the front side. Alternatively, the method steps as recited hereinabove for the rear surface may also be applied to the front main surface of the solar cell.

In a method according to embodiments of the present invention, the substrate, e.g. silicon substrate, may be an ultra-thin substrate, which is typically thinner than 250 micron, preferably thinner than 200 micron, or more preferred thinner than 150 micron. Reducing the thickness of the substrate allows a more efficient use of prime material, hence a lower cost. However, ultra-thin substrates may bow under or after certain treatments, and embodiments of the present invention improve the resistance against bowing of such ultra-thin substrates, therefore reducing at least some of the difficulties of the use of ultra-thin substrates for photovoltaic device, for instance solar cell, fabrication.

In a particular embodiment, the first aspect of the present invention provides a method for the production of a photovoltaic device, for instance solar cell, comprising:
1. providing a silicon substrate or silicon layer or a silicon thin film having a front main surface and a rear surface,
2. depositing a dielectric layer on the rear surface, for example, the dielectric layer having a thickness larger than 100 nm, e.g. between 200 nm and 1200 nm,
3. depositing a passivation layer comprising hydrogenated SiN on top of the dielectric layer,
4. forming holes in the dielectric layer and the SiN:H layer,
5. depositing a layer of contacting material onto the dielectric layer, hereby filling the holes, and
6. applying a high temperature step, i.e. applying a temperature between 600 and 1000 degrees Celsius to the contacting material.

Features of other embodiments of the present invention as recited hereinabove can be combined with this particular embodiment as applicable, and not merely as set out in the present description.

In a second aspect of the present invention a photovoltaic device as for instance a solar cell device is disclosed, corresponding to the methods of the first aspect of the invention. Other photovoltaic devices are possible, as for instance radiation detectors. It should be understood that motivations, variations, alternative embodiments, limitations, etc. which are explained in the context of the method, also apply to the device according to the present invention.

In a second aspect of the present invention, a photovoltaic device as for instance a solar cell device is disclosed comprising
1. a semiconductor substrate, e.g. silicon substrate, or layer, e.g. silicon layer, or thin film, e.g. silicon thin film, having a front main surface for collecting impinging light, e.g. sunlight, and a rear surface opposite to the front main surface,
2. a dielectric layer on the rear surface, the dielectric layer having a thickness larger than 100 nm, preferably larger than 150 nm,
3. a passivation layer comprising hydrogenated SiN on top of said dielectric layer, and
4. back contacts through said dielectric layer or wide bandgap semiconductor layer and said passivation layer.

The back contacts are obtained by forming holes in the dielectric layer and said passivation layer, depositing a layer of contacting material onto the passivation layer, hereby filling the holes, and applying a high temperature step to the layer of contacting material, in which the high temperature step is a contact firing step and is performed at a temperature higher than 730 degrees Celsius and below 960 degrees Celsius.

If a silicon substrate is used, any kind of silicon substrate may be used. Some examples of silicon substrates are Czochralski Si (cz-Si) wafers, Float-Zone (fz-Si) Si wafers, multicrystalline Si (mc-Si) wafers and Ribbon Si wafers. Some examples of layers are polycrystalline silicon layers, which can be put on glass or glass-ceramic, or mono crystalline Silicon layers obtained by a lift-off process.

In a first embodiment of the second aspect of the present invention, the dielectric layer on the rear surface may consist of a SiN layer with a thickness larger than 100 nm, preferably with a thickness larger than 200 nm. In a preferred embodiment, the deposited SiN layer is a hydrogenated SiN layer.

In a second embodiment of the second aspect, a photovoltaic device as for instance a solar cell device is disclosed comprising
1. a semiconductor substrate, e.g. silicon substrate, or layer, e.g. silicon layer, or thin film, e.g. silicon thin film, having a front main surface for collecting impinging light, e.g. sunlight, and a rear surface opposite to the front main surface,
2. a dielectric layer stack on the rear surface, wherein the dielectric layer stack comprises a sub-stack of dielectric layers and/or wide bandgap semiconductor layers, the sub-stack having a thickness larger than 100 nm, preferably larger than 150 nm, and the dielectric layer stack having a thickness larger than 200 nm, preferably larger than 250 nm, and
3. back contacts through said dielectric layer stack.

The dielectric layer stack may comprise a passivation layer on top of the sub-stack of dielectric layers and/or wide bandgap semiconductor layers, e.g. a SiN layer. In this case, the passivation layer does not form part of the stack with a thickness larger than 200 nm.

In a photovoltaic device according to embodiments of the present invention, a high quality layer, e.g. an aluminum oxide layer, may be present between the rear surface of the substrate and the sub-stack of dielectric layers and/or wide bandgap semiconductor layers.

In embodiments of the second aspect of the present invention, the thickness of the dielectric layer or sub-stack of dielectric layers and/or wide bandgap semiconductor layers may be between 100 nm and 5000 nm, preferably between 100 nm and 4000 nm, more preferred between 100 nm and 3000 nm, still more preferred between 100 nm and 2000 nm, still more preferred between 100 nm and 1500 nm, still more preferred between 150 nm and 1200 nm, more preferably between 200 nm and 1200 nm, still more preferably between 600 nm and 1200 nm or between 800 nm and 1200 nm. Alternatively, the thickness of the dielectric layer or dielectric layer stack may be between 400 nm and 800 nm. In embodiments of the present invention, the minimal thickness of the dielectric layer or dielectric layer stack depends on the material which is employed and is determined by the amount of material which is necessary to act simultaneously as a diffusion mask during emitter diffusion, while still being of use for surface passivation and contact formation. For pyrox SiOx this is typically about 300 nm, for Al2O3/TiO2 pseudobinary alloys (PBAs) deposited by solgel this is about 150 nm. Those thickness values are only indicative and a deviation of 10%, 20% or more from the given values is possible. Also a combination, or a stack of layers, of different materials are possible and would lead to a pre-determined threshold thickness for the combined diffusion mask, surface passivation and contact formation process.

In embodiments of the second aspect of the present invention, the dielectric layer or sub-stack of dielectric layers and/or wide bandgap semiconductor layers may comprise a low quality dielectric layer. The low quality dielectric layer may comprise a low quality oxide, such as low quality amorphous oxide, e.g. amorphous silicon oxide, which can reduce production costs when compared to production of high quality oxide. In embodiments of the present invention, the dielectric layer may be a deposited dielectric layer. Deposited dielectric layers are typically of lower quality than grown dielectric layers.

The low-quality dielectric, e.g. amorphous oxide, can for instance be a Spin-on oxide or APCVD (Atmospheric pressure) pyrolithic oxide, spin-on, spray-on or dip oxide.... It can be for instance a silicon oxide, TiO2 (e.g. deposited by solgel), or Al2O3/TiO2 pseudobinary alloys (PBAs).

A low-quality amorphous oxide presents several advantages with respect to high quality, grown oxides, in that it can e.g. be cheaper and less harmful to the lifetime of the bulk material.

In embodiments of the present invention, the back contacts are formed by holes in the dielectric layer and the passivation layer or in the dielectric layer stack, possibly also provided with a passivation layer, which holes are filled with electrically conductive contact material.

In embodiments of the present invention, the layer of contacting material may be discontinuous. This means that different areas can be covered with contacting material, whereby those different areas are not connected to each other. In an advantageous example of a discontinuous layer of contacting material, the contacting material can be present essentially in the holes.

In alternative embodiments of the present invention, the back contacts may be formed by applying a continuous layer of contacting material, e.g. metal, and applying local firing of the layer of contacting material, i.e. local heating e.g. by means of a laser. In this case, the continuous layer of contacting material can also serve as a back mirror.

In still alternative embodiments of the present invention, back contacts may be formed by applying a patterned metal layer at the passivated rear surface of the photovoltaic device, for instance solar cell, and applying a general heating step.

In embodiments of the present invention, the device according to the present invention may be bifacial.

In embodiments of the present invention, the front main surface may comprise a typical solar cell front surface. Alternatively, the front main surface may comprise a structure as described hereinabove.

In certain advantageous embodiments the substrate has a thickness smaller than 250 micron or smaller than 200 or 150 micron. Reducing the thickness of the substrate allows a more efficient use of prime material, hence a lower cost.

It has been shown that working solar cells with a substrate thickness down to 90 µm thickness can be produced (efficiencies of 11% have been easily achieved) with the invention without showing any bowing problem despite the use of screen printed Al paste for contacting on the full rear side.

In a particular embodiment, the second aspect of the present invention provides a photovoltaic device as for instance a solar cell device, comprising
1. a silicon substrate or silicon layer or silicon thin film having a front main surface and a rear surface,
2. a dielectric layer on the rear surface, the dielectric layer having a thickness larger than 100 nm, e.g. between 200 nm and 1200 nm,
3. a passivation layer comprising hydrogenated SiN on top of the dielectric layer,
4. holes through the dielectric layer and the SiN:H layer, and
5. a layer of contacting material onto the dielectric layer, the layer also filling the holes.

It should be noted that some layers formed or produced, grown or deposited by a certain technique can successfully afterwards be investigated to retrieve their formation technique. An example of such a technique is for instance the inspection of TEM (Tunnelling electron microscopy) pictures, but other techniques can be used, which are known to a person skilled in the art.

The method according to the present invention can be applied in the field of back contacted solar cells. This would result in a back contacted solar cell, which can further comprise features of the devices according to the present invention.

Particular and preferred aspects of the invention are set out in the accompanying independent and dependent claims. Features from the dependent claims may be combined with features of the independent claims and with features of other dependent claims as appropriate and not merely as explicitly set out in the claims.

### Description of the figures

Fig. 1. Example of a photovoltaic device, as e.g. a solar cell, fabrication process according to an embodiment of the present invention.
Fig. 2. Illustration of embodiments according to the present invention.
Fig. 3. Effective lifetime of a group of bifacial Cz silicon wafers after different passivation and thermal treatments. The samples are measured at an injection level of 10¹⁴ excess carriers/cm³. It is shown that deposition and firing of hydrogenated SiNx are beneficial to the layer on both as deposited and thermally treated/diffused (cycle in POCl₃ diffusion furnace) samples.
Fig. 4. The open circuit voltage of the cell, a figure of merit parameter that correlates directly to the quality of the rear side passivation layer, is shown as a function of the thickness of the deposited low quality dielectric.
Fig. 5 illustrates the open circuit voltage of three cells with different rear surface passivation schemes.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

The present invention will be explained with respect to silicon substrates, but the invention is not limited thereto. Other suitable substrates can be used as well.

In a first embodiment of the present invention, a thick SiN layer is deposited on a silicon substrate. The SiN layer has a thickness larger than 100 nm, preferably a thickness of at least 180 nm. When formed into a solar cell, such structure shows increased cell efficiencies for higher dielectric thicknesses. Furthermore, the cell efficiencies for dielectric layers thicker than 100 nm have been found to be better than prior art cell efficiencies with lower dielectric thicknesses.

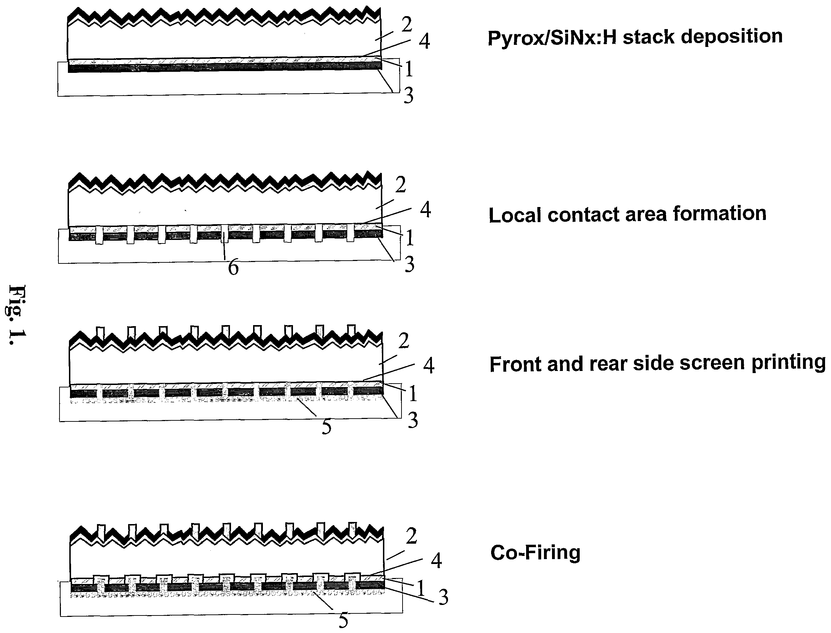

In a second embodiment of the present invention, as illustrated in Fig. 1, for instance more than 100 nm, 200 nm, 800 nm of dielectric 1, e.g. oxide, are deposited on the substrate surface 4, e.g. silicon surface. On top of the dielectric 1, a layer of SiNx:H 3 optimized for hydrogen release is deposited. The substrate surface passivation is improved by means of hydrogenation.

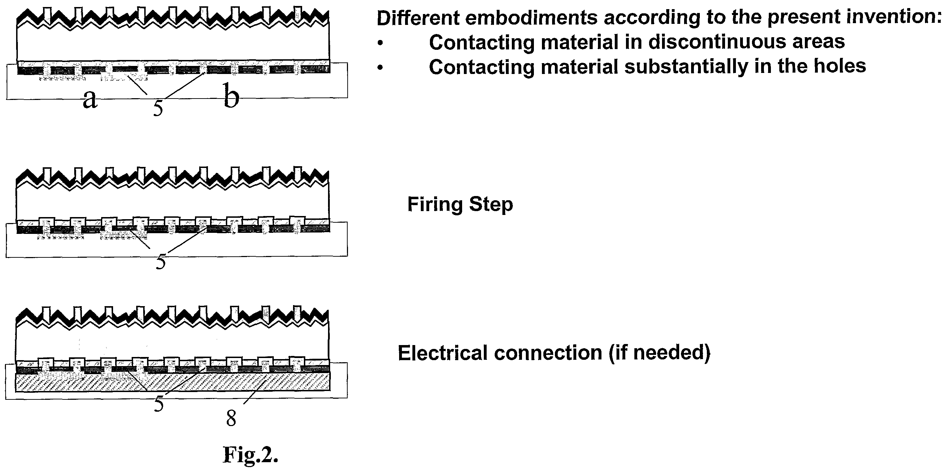

The dielectric layer stack 1, 3 thus formed is then opened up by forming holes 6 in the stack, to form local contact areas. A layer of contacting material 5 is applied onto said dielectric layer stack 1, 3, hereby filling the holes. This may be done by screen printing, for example by simultaneously or consecutively front and rear side screen printing. A high temperature step such as cofiring is then applied in order to make contact with the substrate 2. The contacting material 5 may be applied as a continuous layer, or as a discontinuous layer as in Fig. 2. This means that different areas can be covered with contacting material 5, whereby those different areas are not electrically connected to each other. These areas can be electrically connected later on by electrical connection means 8 in order to allow an optimal current flow through the device and/or an external load.

A rear side passivation layer has thus been developed that (a) retains or improves its surface passivation qualities during the firing step, that (b) cannot be fired through by commercial Aluminum screen printed paste, while there exists a least-damage, fast technique to locally remove such layer prior to metallisation, and that (c) does not interact with the capping metal layer during the firing process or when local contacts are otherwise formed through it.

Due to its characteristics this process
- provides an efficient surface passivation, where
- it is possible to make local (BSF) contacts, and
- the process eliminates the bowing problems when using ultra-thin wafers or substrates (e.g. problems when combined with Al screen printed paste on ultra-thin wafers).

A generic low quality amorphous oxide was deposited (e.g. SiO₂, SiOx, SOG, TiO₂, Al₂O₃... or their pseudo-alloys, SiONx,) on the solar cell's rear side silicon surface (e.g. by APCVD, or spin coating). The surface passivation properties of the dielectric layer were improved by depositing an optimized hydrogenated dielectric layer (namely: SiNx:H). Such stacks retain the passivation properties during short high temperature treatments. The passivation properties are even improved during this treatment. This feature is important as it enables the use of the contact co-firing process that takes place in most of the industrial silicon solar cells' process sequence. Moreover, given that a) it is resistant to firing; i.e. it doesn't lose its relevant characteristics, b) it cannot be fired through, but c) it is possible to create local openings or holes in it by techniques such as e.g. etching paste or laser ablation, this invention enables for an easy way to create Local Back Surface Field (LBSF) contacts by selective alloying, during the firing process itself. The alloying process partially recovers any surface damage that may have incurred during the opening of the layer, thereby further simplifying the process. During the alloying, part of the Si surface and subsurface forms an alloy with the metal. The surface termination is therefore not crucial, as it would be e.g. when depositing another semiconductor, or a dielectric. A back surface field is formed and the effect of residual subsurface damage will be reduced, to a certain extent.

In an example, illustrated in Fig. 1, pyrolithic silicon oxide (Pyrox) 1 was deposited by atmospheric pressure chemical vapor deposition (APCVD) onto a silicon substrate 2. As opposed to conventional thermal oxides, or wet oxides, which are known to be excellent for surface passivation of silicon, pyrox has poor passivation properties and finds its application in microelectronics as an inexpensive and convenient diffusion mask, or dopant source. In fact, it can be deposited at about 400 °C, which means that even low quality silicon material can withstand the deposition process without risk of thermal poisoning.

Thermal annealing can, to some extent, improve the surface passivation quality of pyrox. However, prolonged treatments lead to a degradation of the sample.

Moreover, it has been observed that there may be a degradation of the surface passivation qualities with air exposure.

Hydrogenated silicon nitride (SiNx:H) 3 can be used to stably improve the quality of the pyrox/silicon interface 4. It is known that silicon nitride can lead to excellent surface and bulk passivation properties on silicon, reason for which it is widely used in solar cell technology. However, its application for rear side passivation of an industrial solar cell is not straightforward. There exists an interaction between silicon nitride and metal capping layer (i.e. the rear surface contact of the solar cell), that leads to decreased surface passivation and cell efficiency (it is believed that this interaction is more than a "shunt" effect as described e.g. in Dauwe S., Mittelstadt L., Metz A., Hezel R., "Experimental evidence of parasitic shunting in silicon nitride rear surface passivated solar cells", Prog. Photovolt. Res. Appl., 10 (4), 271-278, (2002)). Also the nitride recipes which are known to be best at surface passivation cannot withstand high temperature treatments such as the one that takes place during cofiring of the contacts. On the other hand, it is known that hydrogenated silicon nitride can release hydrogen during high temperature annealing treatments.

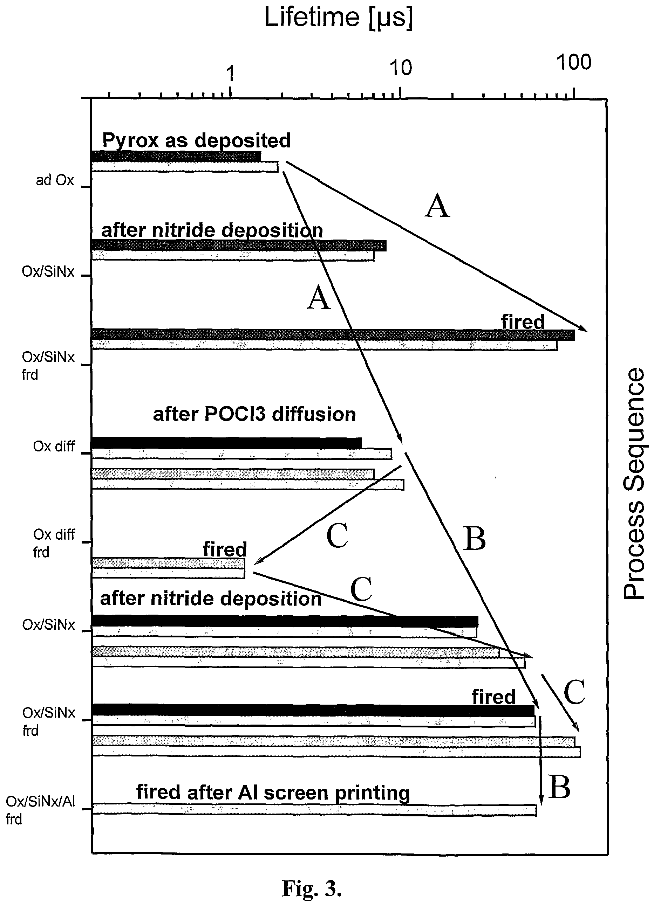

It is believed that the silicon nitride is used as a hydrogen source for the low quality oxide underneath, thereby significantly improving its surface passivation properties. In fig. 3, the trends observed in the effective lifetimes in Cz wafers after different passivation and thermal treatments are shown. Assuming that the bulk lifetime is essentially constant, the effective lifetimes give a direct indication of the quality of surface passivation. The pyrox layer in this experiment was 800 nm thick, excluding any field-induced passivation effect from the overlying silicon nitride, which is in the prior art believed to be the reason for the good passivation quality.

Right after the deposition, the surface passivation quality of the pyrox is very poor. After nitride deposition on top of the pyrox layer there is a limited improvement (path A) and finally when firing the samples, an excellent surface passivation is achieved. Thermal cycles, like e.g. the ones that takes place with POCI3 diffusion (see fig. 3), lead to a limited surface passivation improvement like the one observed after nitride deposition, before firing. Nitride deposition on top of the pyrox and firing, once again, lead to excellent surface passivation (path B). Firing with or without a metal layer on top lead to the same good results (see the example after Al screen printing in fig. 3). It has been shown that firing alone (without the SiN layer deposition step first) is not beneficial. If firing is applied to the pyrox layer alone, there is a degradation of its surface passivation properties. Nonetheless, these can be recovered by subsequent nitride deposition and firing (path C).

A further advantage of the technique is that since it can be applied to low quality oxides, it can be applied directly on diffusion mask oxides too, greatly simplifying the solar cell process.

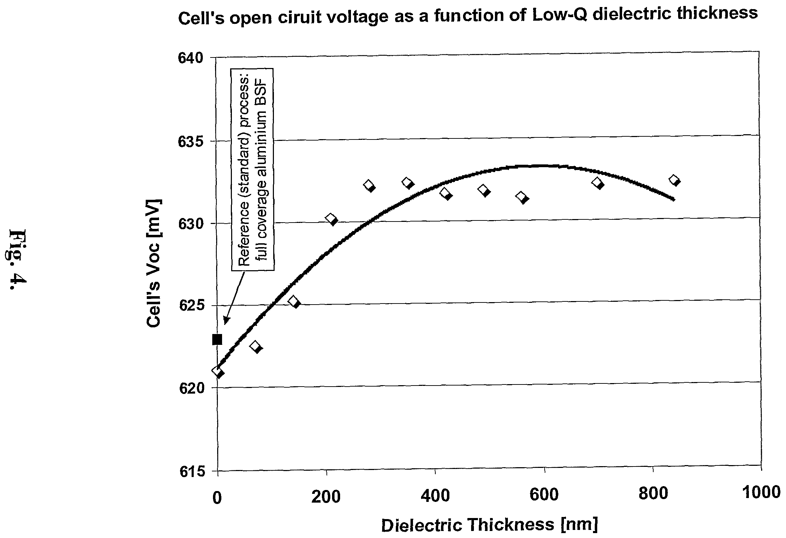

Dielectric layer stacks with a dielectric layer with thickness between 100 nm and 1500 nm have been deposited. When implemented in solar cells, the open circuit voltage has been measured as a function of the low quality dielectric thickness, as illustrated in Fig. 4 in particular for oxide. It can be seen from the graph in Fig. 4 that dielectric thicknesses between 100 nm and 800 nm provide improved open circuit voltages with respect to the open circuit voltage of a cell obtained by a standard prior art process of full coverage aluminium BSF.

Other stacks than the above-mentioned silicon (substrate)/low quality oxide (dielectric layer)/silicon nitride (passivation layer) stack can for example be
- silicon (substrate)/dielectric or wide bandgap (>2eV, preferably >3eV) semiconductor, such as e.g. silicon carbide (SiC), aluminum nitride (AIN), gallium nitride (GaN) or boron nitride (BN) /silicon nitride
- silicon (substrate) / silicon nitride / low quality oxide
- silicon (substrate) / silicon nitride / wide bandgap (>2eV, preferably >3eV) semiconductor or dielectric
- silicon (substrate) / Al2O3 / low quality oxide
- silicon (substrate) / Al2O3 / wide bandgap (>2eV, preferably >3eV) semiconductor or dielectric
In each of the above stacks, according to the present invention, the dielectric layer stack has a thickness above 100 nm.

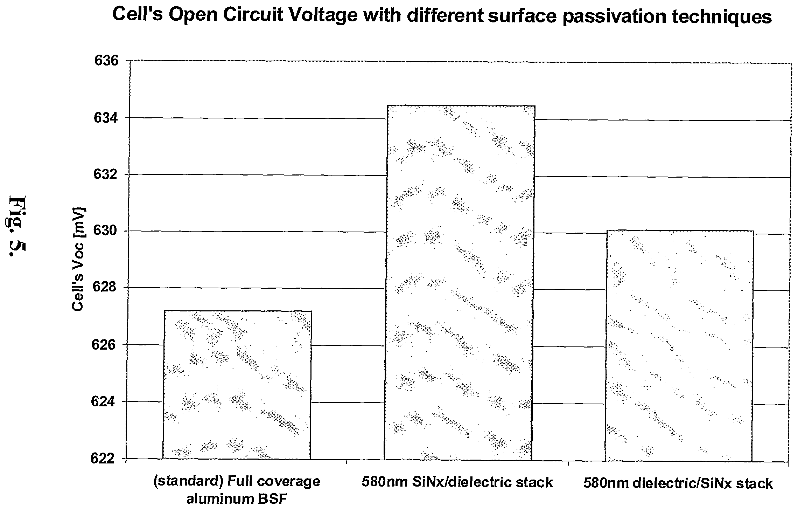

Fig. 5 illustrates the open circuit voltage of three cells with different rear surface passivation schemes: the standard full coverage screen printed aluminum BSF used in crystalline silicon solar cell production (left); a SiNx/dielectric stack, with dielectric on the silicon substrate, the dielectric stack having a thickness of approximately 580 nm (middle); and a dielectric/SiNx stack with SiNx on the silicon substrate, the dielectric stack also having a thickness of approximately 580 nm (right). It can be seen that both thick dielectric layer stacks according to the present invention, i.e. the dielectric layer stacks having a thickness of at least 200 nm, preferably at least 250 nm, provide better results with respect to open circuit voltage than the standard full coverage aluminum BSF.

### Examples of Process sequences

A typical process sequence for surface passivation can comprise the steps of
- Chemical cleaning
- Low quality oxide deposition (100 to 1500 nm)
- Silicon nitride deposition; for instance Low Frequency (450 kHz) direct PECVD Hydrogenated SiNx deposited at 400 degrees from SiH4 and NH3 precursors
- Firing in a three-zone belt furnace, at high belt speed (e.g. more than 100 inch/min), peak set temperature of the furnace up to 960 °C

This method for surface passivation can be integrated in the process sequence of a solar cell, in different situations:
A) deposition after diffusion
   - Front side texturing
   - Diffusion, e.g. P diffusion, resulting in doped, e.g. P-doped, regions all around the substrate, i.e. both at the front surface and the rear surface
   - Glass removal, e.g. P-glass removal,
   - Etching of Si at the rear (sufficient to remove P-doped region at rear)
   - Chemical cleaning
   - Low quality oxide deposition
   - Silicon nitride deposition (rear and possibly front)
   - Forming of back contacts, e.g. by
      - Opening of the local contacts (e.g. by etching paste, scribing or laser ablation)
      - Metal deposition (e.g. evaporation, sputtering, screen printing)
      - Firing in a commercial belt furnace
B) Before diffusion
   - Chemical cleaning
   - Low quality oxide deposition
   - Diffusion (will only take place at the front surface to form the emitter, as at the rear surface low-quality oxide has been deposited and functions as a mask for the diffusion)
   - Silicon nitride deposition (rear and possibly front side)
   - Forming of back contacts, e.g. by
      - Opening of local contacts (e.g. by etching paste, scribing or laser ablation)
      - Metal deposition (e.g. evaporation, sputtering, screen printing)
      - Firing in a belt furnace

## Claims

1. Method for the production of a photovoltaic device comprising:
i. providing a semiconductor substrate having a front main surface for collecting impinging light and a rear surface opposite to the front main surface,
ii. depositing a dielectric layer on said rear surface,
iii. depositing a passivation layer comprising hydrogenated SiN on top of said dielectric layer, and
iv. forming back contacts through said dielectric layer and said passivation layer,
wherein said forming back contacts comprises forming holes in said dielectric layer and said passivation layer, and depositing a layer of contacting material onto said passivation layer, hereby filling said holes,
said method furthermore comprising applying a high temperature step to the layer of contacting material, wherein said high temperature step is a contact firing step and is performed at a temperature higher than 730 degrees Celsius and below 960 degrees Celsius, **characterized in that** the thickness of the dielectric layer is larger than 100 nm.

2. Method according to claim 1, wherein depositing a dielectric layer on said rear surface, comprises depositing a dielectric layer stack on said rear surface, wherein the dielectric layer stack comprises a sub-stack of dielectric layers and/or wide bandgap semiconductor layers, the sub-stack having a thickness larger than 100 nm, the dielectric layer stack having a thickness larger than 200 nm.

3. Method according to claim 2, furthermore comprising forming a high quality layer in between the substrate and the sub-stack of dielectric layers and/or wide bandgap semiconductor layers.

4. Method according to claim 3, wherein the high-quality layer is an aluminum oxide layer.

5. Method according to any of the previous claims, wherein the thickness of the dielectric layer or sub-stack of dielectric layers and/or wide bandgap semiconductor layers is between 100 nm and 1500 nm, preferably between 150 nm and 1200 nm, more preferably between 200 nm and 1200 nm, still more preferably between 400 nm and 800 nm or between 800 nm and 1200 nm.

6. Method according to any of the previous claims, wherein depositing a dielectric layer or a sub-stack of dielectric layers and/or wide bandgap semiconductor layers comprises depositing a low quality dielectric layer.

7. Method according to claim 1 or 6, wherein depositing a dielectric layer on said rear surface comprises depositing a SiN layer.

8. Method according to claim 6, wherein depositing a sub-stack of dielectric layers and/or wide bandgap semiconductor layers comprises depositing a plurality of low quality dielectric layers.

9. Method according to any of claims 6 to 8, wherein depositing a low quality dielectric layer comprises depositing a low quality oxide.

10. Method according to claim 9, wherein the low quality oxide comprises low quality amorphous oxide.

11. Method according to claim 10, wherein said low-quality amorphous oxide is APCVD pyrolithic oxide, spin-on oxide, spray-on oxide or dip oxide.

12. Method according to any of the previous claims, wherein said layer of contacting material is discontinuous.

13. Method according to claim 12, wherein during the step of depositing the layer of contacting material, said contacting material is deposited essentially in said holes.

14. Method according to any of the previous claims, wherein depositing a layer of contacting material is performed by evaporation, sputtering or screen printing.

15. Method according to any of the previous claims, wherein forming holes is performed by applying an etching paste, by scribing or by laser ablation.

16. Method according to any of the preceding claims, further comprising a step of diffusion and emitter removal before depositing said dielectric layer or dielectric layer stack.

17. Method according to claim 1 or a claim dependent on claim 1, wherein a step of diffusion is applied after the step of depositing a dielectric layer and before the step of depositing a passivation layer.

18. Method according to claim 17, wherein said dielectric layer is used as a diffusion mask.

19. Method according to any of the preceding claims, wherein said front main surface has undergone a typical solar cell front surface processing.

20. Method according to any of claims 1 to 18, further comprising the steps of the method according to any of the preceding claims applied on the front main surface of the photovoltaic device.

21. Method according to the any of the preceding claims wherein said substrate is thinner than 250 micron, or thinner than 200 or thinner than 150 micron.

22. A photovoltaic device comprising
i. a semiconductor substrate having a front main surface for collecting impinging light and a rear surface opposite to the front main surface,
ii. a dielectric layer on said rear surface,
iii. a passivation layer comprising hydrogenated SiN on top of said dielectric layer, and
iv. back contacts through said dielectric layer and said hydrogenated SiN,
wherein said back contacts are obtained by forming holes in said dielectric layer and said passivation layer, depositing a layer of contacting material onto said passivation layer, hereby filling said holes, and applying a high temperature step to the layer of contacting material, wherein said high temperature step is a contact firing step and is performed at a temperature higher than 730 degrees Celsius and below 960 degrees Celsius, **characterized in that** the thickness of the dielectric layer is larger than 100 nm.

23. Device according to claim 22, wherein the dielectric layer on said rear surface, comprises a dielectric layer stack on said rear surface, wherein the dielectric layer stack comprises a sub-stack of dielectric layers and/or wide bandgap semiconductor layers, the sub-stack having a thickness larger than 100 nm, the dielectric layer stack having a thickness larger than 200 nm.

24. Device according to claim 23, furthermore comprising a high quality layer in between the substrate and the sub-stack of dielectric layers and/or wide bandgap semiconductor layers.

25. Device according to any of claims 22 to 24, wherein the thickness of the dielectric layer or the sub-stack of dielectric layers and/or wide bandgap semiconductor layers is between 100 nm and 1500 nm, preferably between 150 nm and 1200 nm, more preferably between 200 nm and 1200 nm, still more preferably between 400 nm and 800 nm or between 800 nm and 1200 nm.

26. Device according to any of claims 22 to 25, wherein said dielectric layer or said sub-stack of dielectric layers and/or wide bandgap semiconductor layers comprises a low quality dielectric layer.

27. Device according to claim 22 or 26, wherein the dielectric layer is a SiN layer.

28. Device according to claim 26, wherein said low quality dielectric layer is a low quality oxide.

29. Device according to claim 28, wherein said low-quality oxide comprises low quality amorphous oxide.

30. Device according to claim 29, wherein said low-quality amorphous oxide is APCVD pyrolithic oxide, spin-on oxide, spray-on oxide or dip oxide.

31. Device according to any of claims 22 to 30, wherein the back contacts are formed by holes in said dielectric layer and said passivation layer or in said dielectric layer stack, which holes are filled with electrically conductive contacting material.

32. Device according to claim 31, wherein said contacting material is a discontinuous layer of contacting material.

33. Device according to any of claims 31 or 32, wherein said contacting material is present essentially in said holes.

34. Device according to any of claims 22 to 33, wherein said front main surface also comprises a structure according to any of the claims 22 to 33.

35. Device according to any of claims 22 to 33, wherein said front main surface comprises a typical solar cell front surface.

36. Device according to any of claims 22 to 35, wherein said substrate has a thickness smaller than 250 micron or thinner than 200 micron or thinner than 150 micron.

## Patentansprüche

1. Verfahren für die Herstellung einer Photovoltaikvorrichtung, umfassend:
i. Bereitstellen eines Halbleitersubstrats, das eine vordere Hauptfläche zum Sammeln von auftreffendem Licht, und eine der vorderen Hauptfläche gegenüberliegende Rückfläche aufweist,
ii. Abscheiden einer dielektrischen Schicht auf der Rückfläche,
iii. Abscheiden einer Passivierungsschicht, die hydriertes SiN umfasst, auf der dielektrischen Schicht, und
iv. Bilden von Rückseitenkontakten durch die dielektrische Schicht und die Passivierungsschicht hindurch,
wobei das Bilden von Rückseitenkontakten das Bilden von Löchern in der dielektrischen Schicht und der Passivierungsschicht, und Abscheiden einer Schicht aus Kontaktierungsmaterial auf der Passivierungsschicht umfasst, wodurch die Löcher gefüllt werden,
wobei das Verfahren weiter das Anwenden eines Hochtemperaturschritts auf die Kontaktierungsmaterialschicht umfasst, wobei der Hochtemperaturschritt ein Kontaktbrennschritt ist und bei einer Temperatur von höher als 730 Grad Celsius und unter 960 Grad Celsius durchgeführt wird, **dadurch gekennzeichnet, dass** die Dicke der dielektrischen Schicht mehr als 100 nm beträgt.

2. Verfahren nach Anspruch 1, wobei das Abscheiden einer dielektrischen Schicht auf der Rückfläche das Abscheiden eines dielektrischen Schichtenstapels auf der Rückfläche umfasst, wobei der dielektrische Schichtenstapel einen Teilstapel aus dielektrischen Schichten und/oder Halbleiterschichten mit großer Bandlücke umfasst, wobei der Teilstapel eine Dicke von mehr als 100 nm aufweist, wobei der dielektrische Schichtenstapel eine Dicke von mehr als 200 nm aufweist.

3. Verfahren nach Anspruch 2, weiter das Bilden einer qualitativ hochwertigen Schicht zwischen dem Substrat und dem Teilstapel aus dielektrischen Schichten und/oder Halbleiterschichten mit großer Bandlücke umfassend.

4. Verfahren nach Anspruch 3, wobei die qualitativ hochwertige Schicht eine Aluminiumoxidschicht ist.

5. Verfahren nach einem der vorstehenden Ansprüche, wobei die Dicke der dielektrischen Schicht oder des Teilstapels aus dielektrischen Schichten und/oder Halbleiterschichten mit großer Bandlücke zwischen 100 nm und 1500 nm, vorzugsweise zwischen 150 nm und 1200 nm, stärker bevorzugt zwischen 200 nm und 1200 nm, noch stärker bevorzugt zwischen 400 nm und 800 nm oder zwischen 800 nm und 1200 nm beträgt.

6. Verfahren nach einem der vorstehenden Ansprüche, wobei das Abscheiden einer dielektrischen Schicht oder eines Teilstapels aus dielektrischen Schichten und/oder Halbleiterschichten mit großer Bandlücke das Abscheiden einer qualitativ geringwertigen dielektrischen Schicht umfasst.

7. Verfahren nach Anspruch 1 oder 6, wobei das Abscheiden einer dielektrischen Schicht auf der Rückfläche das Abscheiden einer SiN-Schicht umfasst.

8. Verfahren nach Anspruch 6, wobei das Abscheiden eines Teilstapels aus dielektrischen Schichten und/oder Halbleiterschichten mit großer Bandlücke das Abscheiden einer Vielzahl von qualitativ geringwertigen dielektrischen Schichten umfasst.

9. Verfahren nach einem der Ansprüche 6 bis 8, wobei das Abscheiden einer qualitativ geringwertigen dielektrischen Schicht das Abscheiden eines qualitativ geringwertigen Oxids umfasst.

10. Verfahren nach Anspruch 9, wobei das qualitativ geringwertige Oxid qualitativ geringwertiges amorphes Oxid umfasst.

11. Verfahren nach Anspruch 10, wobei das qualitativ geringwertige amorphe Oxid APCVD pyrolytisches Oxid, Schleuderoxid, Sprühoxid oder Tauchoxid ist.

12. Verfahren nach einem der vorstehenden Ansprüche, wobei die Kontaktierungsmaterialschicht nicht durchgehend ist.

13. Verfahren nach Anspruch 12, wobei während des Schritts des Abscheidens der Kontaktierungsmaterialschicht das Kontaktierungsmaterial im Wesentlichen in den Löchern abgeschieden wird.

14. Verfahren nach einem der vorstehenden Ansprüche, wobei das Abscheiden einer Kontaktierungsmaterialschicht durch Aufdampfen, Sputtern oder Siebdruck durchgeführt wird.

15. Verfahren nach einem der vorstehenden Ansprüche, wobei das Bilden von Löchern durch Anwenden einer Ätzpaste, durch Ritzen oder durch Laserablation durchgeführt wird.

16. Verfahren nach einem der vorstehenden Ansprüche, weiter einen Schritt der Diffusion und Emitter-Entfernung vor dem Abscheiden der dielektrischen Schicht oder des dielektrischen Schichtenstapels umfassend.

17. Verfahren nach Anspruch 1 oder einem von Anspruch 1 abhängigen Anspruch, wobei ein Diffusionsschritt nach dem Schritt des Abscheidens einer dielektrischen Schicht und vor dem Schritt des Abscheidens einer Passivierungsschicht angewendet wird.

18. Verfahren nach Anspruch 17, wobei die dielektrische Schicht als eine Diffusionsmaske verwendet wird.

19. Verfahren nach einem der vorstehenden Ansprüche, wobei die vordere Hauptfläche eine typische Solarzellen-Vorderflächenbearbeitung durchlaufen hat.

20. Verfahren nach einem der Ansprüche 1 bis 18, weiter die Schritte des Verfahrens nach einem der vorstehenden Ansprüche umfassend, die an der vorderen Hauptfläche der Photovoltaikvorrichtung angewendet werden.

21. Verfahren nach dem/einen der vorstehenden Ansprüche, wobei das Substrat dünner als 250 Mikron, oder dünner als 200 oder dünner als 150 Mikron ist.

22. Photovoltaikvorrichtung, umfassend
i. ein Halbleitersubstrat, das eine vordere Hauptfläche zum Sammeln von auftreffendem Licht, und eine der vorderen Hauptfläche gegenüberliegende Rückfläche aufweist,
ii. eine dielektrische Schicht auf der Rückfläche,
iii. eine hydriertes SiN umfassende Passivierungsschicht auf der dielektrischen Schicht, und
iv. Rückseitenkontakte durch die dielektrische Schicht und das hydrierte SiN hindurch,
wobei die Rückseitenkontakte durch Bilden von Löchern in der dielektrischen Schicht und der Passivierungsschicht, Abscheiden einer Schicht aus Kontaktierungsmaterial auf der Passivierungsschicht, wodurch die Löcher gefüllt werden, und Anwenden eines Hochtemperaturschritts auf die Kontaktierungsmaterialschicht erhalten werden, wobei der Hochtemperaturschritt ein Kontaktbrennschritt ist und bei einer Temperatur von höher als 730 Grad Celsius und unter 960 Grad Celsius durchgeführt wird, **dadurch gekennzeichnet, dass** die Dicke der dielektrischen Schicht mehr als 100 nm beträgt.

23. Vorrichtung nach Anspruch 22, wobei die dielektrische Schicht auf der Rückfläche einen dielektrischen Schichtenstapel auf der Rückfläche umfasst, wobei der dielektrische Schichtenstapel einen Teilstapel aus dielektrischen Schichten und/oder Halbleiterschichten mit großer Bandlücke umfasst, wobei der Teilstapel eine Dicke von mehr als 100 nm aufweist, wobei der dielektrische Schichtenstapel eine Dicke von mehr als 200 nm aufweist.

24. Vorrichtung nach Anspruch 23, weiter eine qualitativ hochwertige Schicht zwischen dem Substrat und dem Teilstapel aus dielektrischen Schichten und/oder Halbleiterschichten mit großer Bandlücke umfassend.

25. Vorrichtung nach einem der Ansprüche 22 bis 24, wobei die Dicke der dielektrischen Schicht oder des Teilstapels aus dielektrischen Schichten und/oder Halbleiterschichten mit großer Bandlücke zwischen 100 nm und 1500 nm, vorzugsweise zwischen 150 nm und 1200 nm, stärker bevorzugt zwischen 200 nm und 1200 nm, noch stärker bevorzugt zwischen 400 nm und 800 nm oder zwischen 800 nm und 1200 nm beträgt.

26. Vorrichtung nach einem der Ansprüche 22 bis 25, wobei die dielektrische Schicht oder der Teilstapel aus dielektrischen Schichten und/oder Halbleiterschichten mit großer Bandlücke eine qualitativ geringwertige dielektrische Schicht umfasst.

27. Vorrichtung nach Anspruch 22 oder 26, wobei die dielektrische Schicht eine SiN-Schicht ist.

28. Vorrichtung nach Anspruch 26, wobei die qualitativ geringwertige dielektrische Schicht ein qualitativ geringwertiges Oxid ist.

29. Vorrichtung nach Anspruch 28, wobei das qualitativ geringwertige Oxid qualitativ geringwertiges amorphes Oxid umfasst.

30. Vorrichtung nach Anspruch 29, wobei das qualitativ geringwertige amorphe Oxid APCVD pyrolytisches Oxid, Schleuderoxid, Sprühoxid oder Tauchoxid ist.

31. Vorrichtung nach einem der Ansprüche 22 bis 30, wobei die Rückseitenkontakte von Löchern in der dielektrischen Schicht und der Passivierungsschicht oder in dem dielektrischen Schichtenstapel gebildet werden, welche Löcher mit elektrisch leitfähigem Kontaktierungsmaterial gefüllt sind.

32. Vorrichtung nach Anspruch 31, wobei das Kontaktierungsmaterial eine nicht durchgehende Kontaktierungsmaterialschicht ist.

33. Vorrichtung nach einem der Ansprüche 31 oder 32, wobei das Kontaktierungsmaterial im Wesentlichen in den Löchern vorhanden ist.

34. Vorrichtung nach einem der Ansprüche 22 bis 33, wobei die vordere Hauptfläche ebenfalls eine Struktur nach einem der Ansprüche 22 bis 33 umfasst.

35. Vorrichtung nach einem der Ansprüche 22 bis 33, wobei die vordere Hauptfläche eine typische Solarzellen-Vorderfläche umfasst.

36. Vorrichtung nach einem der Ansprüche 22 bis 35, wobei das Substrat eine Dicke von kleiner als 250 Mikron oder dünner als 200 Mikron oder dünner als 150 Mikron aufweist.

## Revendications

1. Procédé de production d'un dispositif photovoltaïque comprenant :
i. la fourniture d'un substrat semi-conducteur ayant une surface principale avant pour recueillir une lumière incidente et une surface arrière opposée à la surface principale avant,
ii. le dépôt d'une couche diélectrique sur ladite surface arrière,
iii. le dépôt d'une couche de passivation comprenant du SiN hydrogéné par-dessus ladite couche diélectrique, et
iv. la formation de contacts repos à travers ladite couche diélectrique et ladite couche de passivation,
dans lequel ladite formation de contacts repos comprend la formation de trous dans ladite couche diélectrique et ladite couche de passivation, et le dépôt d'une couche de matériau de mise en contact sur ladite couche de passivation, remplissant ainsi lesdits trous,
ledit procédé comprenant en outre l'application d'une étape à haute température à la couche de matériau de mise en contact, dans lequel ladite étape à haute température est une étape de cuisson de contact et est réalisée à une température supérieure à 730 degrés Celsius et inférieure à 960 degrés Celsius,
**caractérisé en ce que** l'épaisseur de la couche diélectrique est supérieure à 100 nm.

2. Procédé selon la revendication 1, dans lequel le dépôt d'une couche diélectrique sur ladite surface arrière comprend le dépôt d'un empilement de couches diélectriques sur ladite surface arrière, dans lequel l'empilement de couches diélectriques comprend un sous-empilement de couches diélectriques et/ou de couches à semi-conducteur à large bande interdite, le sous-empilement ayant une épaisseur supérieure à 100 nm, l'empilement de couches diélectriques ayant une épaisseur supérieure à 200 nm.

3. Procédé selon la revendication 2, comprenant en outre la formation d'une couche de haute qualité entre le substrat et le sous-empilement de couches diélectriques et/ou des couches à semi-conducteur à large bande interdite.

4. Procédé selon la revendication 3, dans lequel la couche de haute qualité est une couche d'oxyde d'aluminium.

5. Procédé selon l'une quelconque des revendications précédentes, dans lequel l'épaisseur de la couche diélectrique ou du sous-empilement de couches diélectriques et/ou des couches à semi-conducteur à large bande interdite est entre 100 nm et 1 500 nm, de préférence entre 150 nm et 1 200 nm, de préférence encore entre 200 nm et 1 200 nm, encore plus de préférence entre 400 nm et 800 nm ou entre 800 nm et 1 200 nm.

6. Procédé selon l'une quelconque des revendications précédentes, dans lequel le dépôt d'une couche diélectrique ou d'un sous-empilement de couches diélectriques et/ou de couches à semi-conducteur à large bande interdite comprend le dépôt d'une couche diélectrique de faible qualité.

7. Procédé selon la revendication 1 ou 6, dans lequel le dépôt d'une couche diélectrique sur ladite surface arrière comprend le dépôt d'une couche de SiN.

8. Procédé selon la revendication 6, dans lequel le dépôt d'un sous-empilement de couches diélectriques et/ou de couches à semi-conducteur à large bande interdite comprend le dépôt d'une pluralité de couches diélectriques de faible qualité.

9. Procédé selon l'une quelconque des revendications 6 à 8, dans lequel le dépôt d'une couche diélectrique de faible qualité comprend le dépôt d'un oxyde de faible qualité.

10. Procédé selon la revendication 9, dans lequel l'oxyde de faible qualité comprend un oxyde amorphe de faible qualité.

11. Procédé selon la revendication 10, dans lequel ledit oxyde amorphe de faible qualité est un oxyde pyrolytique APCVD, un oxyde appliqué par rotation, un oxyde appliqué par pulvérisation, ou un oxyde appliqué par trempage.

12. Procédé selon l'une quelconque des revendications précédentes, dans lequel ladite couche de matériau de mise en contact est discontinue.

13. Procédé selon la revendication 12, dans lequel pendant l'étape de dépôt de la couche de matériau de mise en contact, ledit matériau de mise en contact est déposé essentiellement dans lesdits trous.

14. Procédé selon l'une quelconque des revendications précédentes, dans lequel le dépôt d'une couche de matériau de mise en contact est réalisé par évaporation, pulvérisation cathodique ou sérigraphie.

15. Procédé selon l'une quelconque des revendications précédentes, dans lequel la formation de trous est réalisée par application d'une pâte pour gravure, par découpage ou par ablation laser.

16. Procédé selon l'une quelconque des revendications précédentes, comprenant en outre une étape de diffusion et d'élimination d'émetteur avant le dépôt de ladite couche diélectrique ou dudit empilement de couches diélectriques.

17. Procédé selon la revendication 1 ou une revendication dépendant de la revendication 1, dans lequel une étape de diffusion est appliquée après l'étape de dépôt d'une couche diélectrique et avant l'étape de dépôt d'une couche de passivation.

18. Procédé selon la revendication 17, dans lequel ladite couche diélectrique est utilisée en tant que masque de diffusion.

19. Procédé selon l'une quelconque des revendications précédentes, dans lequel ladite surface principale avant a subi un traitement de surface avant de cellule solaire typique.

20. Procédé selon l'une quelconque des revendications 1 à 18, comprenant en outre les étapes du procédé selon l'une quelconque des revendications précédentes appliquées sur la surface principale avant du dispositif photovoltaïque.

21. Procédé selon l'une quelconque des revendications précédentes, dans lequel ledit substrat a une épaisseur inférieure à 250 microns, ou inférieure à 200 ou inférieure à 150 microns.

22. Dispositif photovoltaïque comprenant
i. un substrat semi-conducteur ayant une surface principale avant pour recueillir une lumière incidente et une surface arrière opposée à la surface principale avant,
ii. une couche diélectrique sur ladite surface arrière,
iii. une couche de passivation comprenant du SiN hydrogéné par-dessus ladite couche diélectrique, et
iv. des contacts repos à travers ladite couche diélectrique et ledit SiN hydrogéné,
dans lequel lesdits contacts repos sont obtenus par formation de trous dans ladite couche diélectrique et ladite couche de passivation, dépôt d'une couche de matériau de mise en contact sur ladite couche de passivation, remplissant ainsi lesdits trous, et application d'une étape à haute température à la couche de matériau de mise en contact, dans lequel ladite étape à haute température est une étape de cuisson de contact et est réalisée à une température supérieure à 730 degrés Celsius et inférieure à 960 degrés Celsius, **caractérisé en ce que** l'épaisseur de la couche diélectrique est supérieure à 100 nm.

23. Dispositif selon la revendication 22, dans lequel la couche diélectrique sur ladite surface arrière, comprend un empilement de couches diélectriques sur ladite surface arrière, dans lequel l'empilement de couches diélectriques comprend un sous-empilement de couches diélectriques et/ou de couches à semi-conducteur à large bande interdite, le sous-empilement ayant une épaisseur supérieure à 100 nm, l'empilement de couches diélectriques ayant une épaisseur supérieure à 200 nm.

24. Dispositif selon la revendication 23, comprenant en outre une couche de haute qualité entre le substrat et le sous-empilement de couches diélectriques et/ou de couches à semi-conducteur à large bande interdite.

25. Dispositif selon l'une quelconque des revendications 22 à 24, dans lequel l'épaisseur de la couche diélectrique ou du sous-empilement de couches diélectriques et/ou de couches à semi-conducteur à large bande interdite est entre 100 nm et 1 500 nm, de préférence entre 150 nm et 1 200 nm, de préférence encore entre 200 nm et 1 200 nm, encore plus de préférence entre 400 nm et 800 nm ou entre 800 nm et 1 200 nm.

26. Dispositif selon l'une quelconque des revendications 22 à 25, dans lequel ladite couche diélectrique ou ledit sous-empilement de couches diélectriques et/ou de couches à semi-conducteur à large bande interdite comprend une couche diélectrique de faible qualité.

27. Dispositif selon la revendication 22 ou 26, dans lequel la couche diélectrique est une couche de SiN.

28. Dispositif selon la revendication 26, dans lequel ladite couche diélectrique de faible qualité est un oxyde de faible qualité.

29. Dispositif selon la revendication 28, dans lequel ledit oxyde de faible qualité comprend un oxyde amorphe de faible qualité.

30. Dispositif selon la revendication 29, dans lequel ledit oxyde amorphe de faible qualité est un oxyde pyrolytique APCVD, un oxyde appliqué par rotation, un oxyde appliqué par pulvérisation, ou un oxyde appliqué par trempage.

31. Dispositif selon l'une quelconque des revendications 22 à 30, dans lequel les contacts repos sont formés par des trous dans ladite couche diélectrique et ladite couche de passivation ou dans ledit empilement de couches diélectriques, lesquels trous sont remplis d'un matériau de mise en contact électriquement conducteur.

32. Dispositif selon la revendication 31, dans lequel ledit matériau de mise en contact est une couche discontinue de matériau de mise en contact.

33. Dispositif selon l'une quelconque des revendications 31 ou 32, dans lequel ledit matériau de mise en contact est essentiellement présent dans lesdits trous.

34. Dispositif selon l'une quelconque des revendications 22 à 33, dans lequel ladite surface principale avant comprend également une structure selon l'une quelconque des revendications 22 à 33.

35. Dispositif selon l'une quelconque des revendications 22 à 33, dans lequel ladite surface principale avant comprend une surface avant de cellule solaire typique.

36. Dispositif selon l'une quelconque des revendications 22 à 35, dans lequel ledit substrat a une épaisseur inférieure à 250 microns, ou inférieure à 200 microns ou inférieure à 150 microns.
